# EUROPEAN PATENT SPECIFICATION

(11) **EP 0 244 968 B1**
(45) Date of publication and mention of the grant of the patent: **20.01.1993**
(21) Application number: 87303278.3
(22) Date of filing: 14.04.1987
(51) Int. Cl.: H01F 1/08, C23C 14/22

(54) **Method for the thermal treatment of sintered metal permanent magnets**
Verfahren zur thermischen Behandlung von gesinterten Metall-Permanentmagneten
Méthode de traitement thermique d'aimants métalliques frittés

(30) Priority: 07.05.1986 FI 861898
(43) Date of publication of application: 11.11.1987
(73) Proprietor: OUTOKUMPU OY, 00100 Helsinki 10 (FI)
(72) Inventor: Veistinen, Mauri Kalervo, Arlington mMA 02174 (US)
(74) Representative: Barlow, Roy James

(56) References cited:
- EP-A- 0 190 461
- FR-A- 2 234 385
- PATENT ABSTRACTS OF JAPAN, vol. 5, no. 149 (E-75)[821], 19th September 1981; & JP-A-56 81 908

## Description

The present invention relates to a method for the treatment of sintered permanent magnets containing rare earth metals.

Iron, borium and neodymium form the compound Nd₂Fe₁₄B, which has excellent permanent-magnetic properties. The so-called NEO magnets, which are already in commercial production, are mainly composed of the said compound. In addition to neodymium, the NEO magnets can also contain other rare earth metals, such as dysprosium, and in addition to iron also other transition metals such as cobalt.

In the production of the NEO magnets, a cast metal alloy is crushed and pulverized, whereafter the pulverous metal is compacted and sintered. After sintering, the magnets are subjected to thermal treatment in the temperature of 600°C for about an hour in order to increase their internal coercitive force. After the thermal treatment, the magnets undergo a finishing grinding. Because iron and particularly neodymium are very reactive metals, for their several different uses these magnets must finally be coated either by metal or by plastic. Moreover, in many applications a high accuracy in the measures is required of the magnets, wherefore the coating process must be accurately adjustable. As the coating for the NEO magnets, among other materials there has been used aluminium, which can be for instance vacuum evaporated on the magnet surface. Although the method of vacuum evaporation, where the work piece is not heated, is simple and widely used, it has a drawback in that the coating tends to stick rather poorly.

The purpose of the present invention is to eliminate some of the drawbacks of the prior art and to achieve an improved and more secure method for treating sintered permanent magnets so that the magnets can also be utilized in cases where the conditions require a corrosion-proof product. The essential novel features of the invention are enlisted in the appended patent claim 1.

According to the invention, the sintered permanent magnets, particularly those containing rare earth metals, are treated thermally and coated during the same stage in the process. Thus, when the extra coating stage is left out, the new method saves both time and money. In addition to this, the coatings can be made accurate in measures and they will stick properly.

The combination of thermal treatment and coating according to the present invention in the manufacture of permanent magnets - which advantageously have the compound form RE₂T₁₄B, where RE is a rare earth metal such as neodymium, dysprosium, praseodymium or cerium, T is a transition metal such as iron or cobalt, and B is borium - is carried out by advantageously making use of an ion coating method pertaining to the gas phase coating methods. In ion coating, the sintered permanent magnet under treatment is first cleaned on the surface. At this stage the temperature of the permanent magnet rises to between 340-360°C, but the temperature can advantageously be increased higher than this, for example up to 400°C. After surface cleaning, the coating is carried out in the temperature of 550-700°C, advantageously in the temperature between 600-630°C, by means of evaporating the coating material onto the permanent magnet under treatment having a negative charge, so that the evaporated atoms which in the plasma are changed into positive ions, stick onto the surface of the permanent magnet. The evaporation can be carried out for instance by means of an electron beam. Because the coating process as such takes up only a short time, the major part of the duration of the treatment is passed while heating up the permanent magnets. The total duration of the treatment according to the present invention is, however - depending on the size of the permanent magnet in question and on the thickness of the coating layer - between 30 minutes and three hours, advantageously between 50 min - 1,5 h. Thus the duration of the treatment is at best the same as that of the thermal treatment only, if prior art methods are applied.

The ion coating employed in the method of the present invention is accurately adjustable, and the coating sticks well. The achieved thickness of the coating varies between 10-100 µm, advantageously between 15-30 µm, depending on the particular use in question. A suitable coating material for sintered permanent magnets, such as those of the type RE₂T₁₄B, is advantageously for example aluminium. In addition to this, other metals such as nickel, zinc, chromium, titanium, and different compounds of these, can be employed as coating, as well as titanium nitride.

## Claims

1. A method for the thermal treatment of sintered permanent magnets containing rare earth metals, **characterized** in that simultaneous with the thermal treatment, the permanent magnets are also coated by means of a gas phase coating method.

2. The method of claim 1, **characterized** in that the coating of the permanent magnets is carried out by means of the ion coating method.

3. The method of claim 1 or 2, **characterized** in that as regards the compounds of the permanent magnets, they have the form RE₂T₁₄B, where RE is a rare earth metal, T is a transition metal and B is boron.

4. The method of any of the preceding claims, **characterized** in that the thermal treatment and the coating are carried out in the temperature between 550-700°C, advantageously between 600-630°C.

5. The method of any of the preceding claims, **characterized** in that the employed coating material is a metal such as aluminium.

6. The method of the claims 1-4, **characterized** in that the employed coating material is titanium nitride.

## Patentansprüche

1. Verfahren zum thermischen Behandeln gesinterter Permanentmagnete, die Metalle der seltenen Erden enthalten,
dadurch **gekennzeichnet,**
daß die Permanentmagneten gleichzeitig mit der thermischen Behandlung mittels eines Gasphasen-Beschichtungsverfahren beschichtet werden.

2. Verfahren nach Anspruch 1,
dadurch **gekennzeichnet**,
daß die Beschichtung der Permanentmagnete mittels des Ionenbeschichtungsverfahrens durchgeführt wird.

3. Verfahren nach Anspruch 1 oder 2,
dadurch **gekennzeichnet**,
daß die Komponenten der Permanentmagneten einen Verbund der Form RE₂T₁₄B bilden, wobei RE ein Metall der seltenen Erden, T ein Übergangsmetall und B ein Bor-Ion ist.

4. Verfahren nach einem der vorhergehenden Ansprüche,
dadurch **gekennzeichnet**,
daß die thermische Behandlung und die Beschichtung in einem Temperaturbereich zwischen 550° und 700°C, vorzugsweise zwischen 600° und 630°C, durchgeführt werden.

5. Verfahren nach einem der vorhergehenden Ansprüche,
dadurch **gekennzeichnet**,
daß als Beschichtungsmaterial ein Metall, wie z.B. Aluminium, verwendet wird.

6. Verfahren nach den Ansprüchen 1 bis 4,
dadurch **gekennzeichnet**,
daß als Beschichtungsmaterial Titannitrid verwendet wird.

## Revendications

1. Procédé de traitement thermique d'aimants permanents frittés contenant des métaux des terres rares, caractérisé en ce que les aimants permanents sont recouverts aussi d'une couche mince au moyen d'un procédé de revêtement en phase gazeuse, en même temps que le traitement thermique.

2. Procédé selon la revendication 1, caractérisé en ce que le revêtement des aimants permanents est effectué au moyen du procédé de revêtement ionique.

3. Procédé selon la revendication 1 ou 2, caractérisé en ce que les composés des aimants permanents ont la forme RE₂T₁₄B, où RE est un métal des terres rares, T est un métal de transition et B est le bore.

4. Procédé selon une quelconque des revendications précédentes, caractérisé en ce que le traitement thermique et le revêtement sont effectués à une température comprise entre 550 et 700°C, et de manière avantageuse entre 600 et 630°C.

5. Procédé selon une quelconque des revendications précédentes, caractérisé en ce que le matériau de revêtement employé est un métal comme l'aluminium.

6. Procédé selon les revendications 1-4, caractérisé en ce que le matériau de revêtement employé est le nitrure de titane.
